# EUROPEAN PATENT APPLICATION

(11) **EP 2 983 456 A1**
(43) Date of publication of application: **10.02.2016**
(21) Application number: 14778583.6
(22) Date of filing: 02.04.2014
(51) Int. Cl.: H05B 33/04, H01L 51/50, H05B 33/02, H05B 33/06, H05B 33/10

(54) **ORGANIC ELECTROLUMINESCENT DEVICE AND METHOD FOR MANUFACTURING SAME**

(30) Priority: 05.04.2013 JP 2013079967
(71) Applicant: Nitto Denko Corporation, Ibaraki-shi, Osaka 567-8680 (JP)
(72) Inventor: OSAKI Yoshinori, Ibaraki-shi Osaka 567-8680 (JP)
(74) Representative: Grünecker Patent- und Rechtsanwälte PartG mbB
(86) International application number: PCT/JP2014/059718
(87) International publication number: WO 2014/163104

(57) **Abstract**

An organic electroluminescence device 1 of the present invention includes a substrate 2, a laminate 3A including an organic electroluminescence element 3 which includes a first conductive layer 31 provided on the substrate 2 and having a first terminal portion 311, an organic electroluminescence layer 32 provided on the first conductive layer 31, and a second conductive layer 33 provided on the organic electroluminescence layer 32 and having a second terminal portion 331, and an insulating inorganic film 4 that covers the laminate 3A except for the first terminal portion 311 and the second terminal portion 331.

## Description

### TECHNICAL FIELD

The present invention relates to an organic electroluminescence device and a method for producing the same.

### BACKGROUND ART

In general, an organic electroluminescence device has a structure in which an organic electroluminescence element is laminated on a substrate. The organic electroluminescence element has at least a first conductive layer, an organic electroluminescence layer, and a second conductive layer. In recent years, a technique for applying such an organic electroluminescence device to illuminating devices or the like has been studied. Hereinafter, "organic electroluminescence" is simply referred to as "organic EL".

The organic EL element is easily degraded by moisture and oxygen. If the organic EL element is degraded by moisture, it may be unable to maintain stable light emission in the organic EL device over a long period of time. Accordingly, it is necessary to prevent permeation of moisture and oxygen into the organic EL element for preventing degradation of the organic EL device.

Therefore, it has been heretofore known that a sealing plate is laminated on a second conductive layer of an organic EL element with a bonding layer interposed therebetween, and by the sealing plate, moisture is prevented from coming into contact with the organic EL layer (e.g. Patent Document 1).

However, it is difficult to reliably prevent permeation of moisture over a long period of time by the sealing plate alone. The bonding layer generally contains as a main component a resin having low moisture barrier properties. Therefore, there is the problem that moisture permeating through the sealing plate easily reaches the organic EL layer from the bonding layer.

[Patent Document 1] JP 2003-317937 A

### SUMMARY OF THE INVENTION

An object of the present invention is to provide an organic EL device having sufficient moisture barrier properties, and a method for producing the organic EL device.

An organic EL device of the present invention includes a substrate, a laminate including an organic EL element which includes a first conductive layer provided on the substrate and having a first terminal portion, an organic EL layer provided on the first conductive layer, and a second conductive layer provided on the organic EL layer and having a second terminal portion, and an insulating inorganic film that covers the laminate except for the first terminal portion and the second terminal portion.

In a preferable organic EL device of the present invention, the insulating inorganic film further covers the substrate. Preferably, the insulating inorganic film contains a silica-converted product from a polysilazane.

Preferably, the laminate further includes a bonding layer provided on the organic EL element, and a sealing plate bonded to the organic EL element by the bonding layer.

More preferably, the laminate further includes a protective film provided on the organic EL element, a bonding layer provided on the protective film, and a sealing plate bonded to the protective film by the bonding layer.

Preferably, the sealing plate has flexibility. More preferably, the substrate has flexibility.

According to another aspect of the present invention, a method for producing an organic EL device is provided.

The method for producing the organic EL device of the present invention includes the steps of: forming on a substrate a laminate including an organic EL element which includes a first conductive layer having a first terminal portion, an organic EL layer, and a second conductive layer having a second terminal portion; covering the first terminal portion and the second terminal portion with a masking material; bringing the laminate into contact with a treatment liquid containing an insulating inorganic substance; solidifying the treatment liquid to form an inorganic film; and removing the masking material.

Preferably, the treatment liquid contains a polysilazane, and the step of solidifying the treatment liquid includes a silica conversion treatment of the polysilazane.

In the organic EL device according to the present invention, the organic EL element is covered with an insulating inorganic film. Since the inorganic film has moisture barrier properties, permeation of moisture to the inside of the organic EL element can be effectively prevented, so that an organic EL device which is hard to be degraded over a long period of time can be provided.

### BRIEF DESCRIPTION OF THE DRAWINGS

Fig. 1 is a plan view illustrating an organic EL device according to one embodiment of the present invention.
Fig. 2 is an enlarged sectional view taken along the line II-II of the organic EL device in Fig. 1.
Fig. 3 is an enlarged sectional view taken along the line III-III of the organic EL device in Fig. 1.
Fig. 4 is an enlarged sectional view of an organic EL device according to a first modified example of the present invention.
Fig. 5 is an enlarged sectional view of an organic EL device according to a second modified example of the present invention.
Fig. 6 is an enlarged sectional view of an organic EL device according to a third modified example of the present invention.
Fig. 7 is an enlarged sectional view of an organic EL device according to a fourth modified example of the present invention.
Fig. 8 is a schematic side view illustrating a part of a production line of the organic EL device of the present invention.
Fig. 9 is an enlarged sectional view illustrating a laminate with a substrate in which terminal portions are covered with a masking material.

Hereinafter, the present invention will be described with reference to the drawings. It should be noted that dimensions such as a layer thickness and a length in the drawings are different from actual dimensions. In the present specification, the terms "first" and "second" may be added as prefixes. These prefixes, however, are only added in order to distinguish the terms and do not have specific meaning such as order and relative merits.

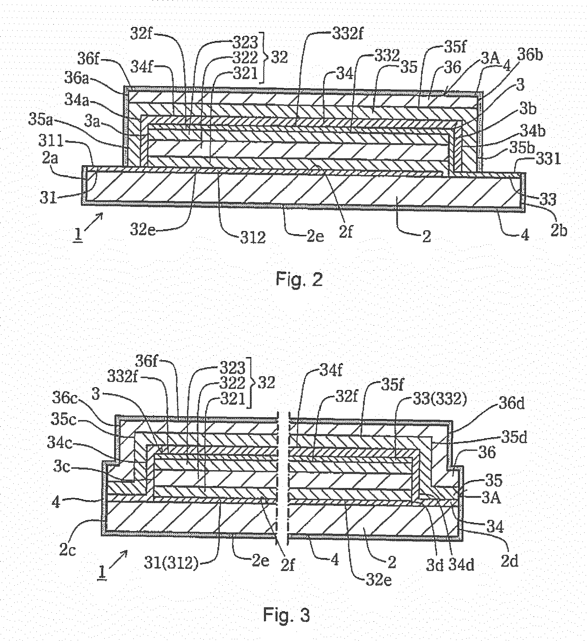

Furthermore, in the present specification, for convenience, "top direction" refers to the upper side and "bottom direction" refers to the lower side, with respect to the organic EL device placed on a horizontal plane as illustrated in Fig. 2 and Fig. 3. Among the surfaces of a member or a portion, the surface on the upper side is referred to as a "front surface", and the surface on the lower side is referred to as a "back surface".

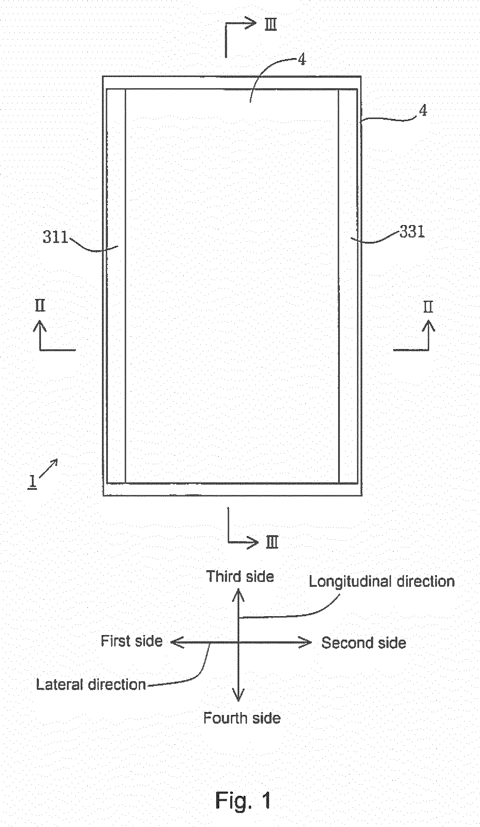

Fig. 1 is a plan view illustrating an organic EL device 1 according to one embodiment of the present invention, and Figs. 2 and 3 are enlarged sectional views of the organic EL device 1. The two dashed lines illustrated in Fig. 3 indicate that depiction of the organic EL device 1 existing between both the dashed lines is omitted for the sake of convenience.

In this embodiment, the organic EL device 1 having a substantially belt-like shape in plan view is used. However, in the present invention, the shape of the organic EL device in plan view is not particularly limited, and the shape of the organic EL device can be changed to a plan-view substantially circular shape, a substantially triangular shape, or the like.

Although the dimensions of the plan-view substantially belt-shaped organic EL device 1 are not particularly limited, in general, the ratio of width : length of the organic EL device 1 is 1 : 3 to 1 : 20 and preferably 1 : 3 to 1 : 10.

As illustrated in Fig. 1 to Fig. 3, the organic EL device 1 according to the present invention has a substrate 2, a laminate 3A provided on the substrate 2, and an insulating inorganic film 4 covering the laminate 3A.

The laminate 3A includes at least an organic EL element 3. In Figs. 2 and 3, the laminate 3A includes the organic EL element 3, and a protective film 34, a bonding layer 35, and a sealing plate 36 which are provided on the organic EL element 3. However, in the present invention, the laminate 3A should include at least the organic EL element 3, and is not required to be provided with the protective film 34, the bonding layer 35 or the sealing plate 36.

The organic EL element 3 includes a first conductive layer 31 having a first terminal portion 311, an organic EL layer 32 provided on the first conductive layer 31, and a second conductive layer 33 provided on the organic EL layer 32 and having a second terminal portion 331. The organic EL layer 32 is laminated on the front surface of the first conductive layer 31, and the second conductive layer 33 is laminated on the front surface of the organic EL layer 32.

The first conductive layer 31 includes the first terminal portion 311 disposed on the outside of the organic EL layer 32, and a first electrode portion 312 disposed under the organic EL layer 32. The second conductive layer 33 includes the second terminal portion 331 disposed on the outside of the organic EL layer 32, and a second electrode portion 332 disposed on the organic EL layer 32.

Both the terminal portions 311 and 331 are portions which constitute a part of the first and second conductive layers 31 and 33, respectively, and directly receive electricity supplied from an external power source. Specifically, both the terminal portions 311 and 331 are portions which constitute a part of both the conductive layers 31 and 33, respectively, and are exposed to the outside air. In the embodiment in Figs. 1 to 3, both the terminal portions 311 and 331 are provided on a front surface 2f of the substrate 2. As described later, however, when an insulating layer is provided between the organic EL element 3 and the substrate 2, both the terminal portions 311 and 331 are provided on the front surface of the insulating layer.

As illustrated in Figs. 1 and 2, the first terminal portion 311 is provided at an end portion of the organic EL device 1 on the first side in the lateral direction, and the second terminal portion 331 is provided at an end portion of the organic EL device 1 on the second side in the lateral direction. Both the terminal portions 311 and 331 are provided in a belt-like shape from an end portion of the organic EL device 1 on the third side in the longitudinal direction to an end portion of the organic EL device 1 on the fourth side in the longitudinal direction.

A connecting unit such as a lead wire is connected to the first terminal portion 311 and the second terminal portion 331 (not illustrated). The connecting unit is further connected to an external power source (not illustrated), and electricity supplied from the external power source is supplied to the first terminal portion 311 and the second terminal portion 331 through the connecting unit.

In the present specification, the left side in Fig. 1, the right side in Fig. 1, the upper side in Fig. 1, and the lower side in Fig. 1 correspond to the first side, the second side, the third side, and the fourth side of the organic EL device, respectively, for the sake of convenience. In Fig. 2, the left side corresponds to the first side, and the right side corresponds to the second side. In Fig. 3, the left side corresponds to the third side, and the right side corresponds to the fourth side.

In the present specification, among the surfaces of a member or a portion, the surface on the first side is referred to as a first side surface, the surface on the second side is referred to as a second side surface, the surface on the third side is referred to as a third side surface, the surface on the fourth side is referred to as a fourth side surface, and these first to fourth side surfaces are referred to collectively as outer peripheral surfaces.

The first side surface and the second side surface of a member or a portion are surfaces which extend from the third side to the fourth side of the organic EL device 1 similarly to the first terminal portion 311 and the second terminal portion 331. The third side surface and the fourth side surface of a member or a portion are surfaces which extend from the first side to the second side of the organic EL device 1, and are continuously connected while crossing the first side surface and the second side surface substantially at a right angle.

The first electrode portion 312 is a portion which is continuously connected to the first terminal portion 311, and the second electrode portion 332 is a portion which is continuously connected to the second terminal portion 331. The first electrode portion 312 and the first terminal portion 311 are integrally formed, and the second electrode portion 332 and the second terminal portion 331 are integrally formed. The first electrode portion 312 is disposed so as to be in contact with a back surface 32e of the organic EL layer 32, and the second electrode portion 332 is disposed so as to be in contact with a front surface 32f of the organic EL layer 32. Electricity directly received by both the terminal portions 311 and 331 is supplied to the organic EL layer 32 by both the electrode portions 312 and 332, and as a result, the organic EL layer 32 emits light.

In the organic EL device 1 of the present invention, the laminate 3A is covered with the insulating inorganic film 4 except for the first terminal portion 311 and the second terminal portion 331. By the inorganic film 4, moisture can be effectively prevented from coming into contact with the organic EL layer 32 of the organic EL element 3.

In the present invention, the phrase "a laminate is covered with an inorganic film except for first and second terminal portions" includes not only a case where the inorganic film is provided on the entire outer surface of the laminate (except for first and second terminal portions), but also a case where the inorganic film is provided on a part of the outer surface of the laminate. When the inorganic film is provided on a part of the outer surface of the laminate, the region provided with the inorganic film is not limited, and can be appropriately changed as long as the moisture barrier properties of the organic EL device can be secured.

In the present specification, it is premised that the first conductive layer 31 of the organic EL device 1 is an anode layer, and the second conductive layer 33 is a cathode layer. However, the organic EL device 1 according to the present invention may have the first conductive layer 31 as a cathode layer, and the second conductive layer 33 as an anode layer.

Hereinafter, the configurations of the members and portions of the organic EL device 1 will be described.

### [Substrate]

The substrate is a plate-shaped member on which a laminate is laminated.

The formation material for the substrate is not particularly limited. Examples of the formation material for the substrate include glass, ceramics, metals, and synthetic resins. The substrate may be either transparent or opaque, but when a bottom emission-type organic EL device is to be formed, a transparent substrate is used.

The substrate is preferably excellent in heat dissipation for preventing an increase in temperature of the organic EL device at the time of driving, and preferably has moisture barrier properties for preventing moisture from coming into contact with the organic EL layer.

In view of heat dissipation and moisture barrier properties, it is preferable to use a metal as a formation material for the substrate. When a metal is used as a formation material for the substrate, it is preferable to provide an insulating layer on the front surface of the substrate for preventing a short-circuit between the substrate and the first conductive layer (anode layer) and second conductive layer (cathode layer).

When a synthetic resin is used as a formation material for the substrate, examples of the synthetic resin include polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylenevinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK) are used, and preferably, polyimide-based resins are used.

When a metal is used as a formation material for the substrate, examples of the metal include stainless steel, iron, aluminum, nickel, cobalt, copper, and alloys thereof, and preferably, stainless steel is used.

Preferably, the substrate has flexibility. Examples of the formation material for the substrate having flexibility include copper and aluminum.

In the present specification, the phrase "having flexibility" means that the substrate has a nature such that when a force is applied to the substrate, the substrate is hardly deformed in all radiation directions in the surface of the substrate, but considerably deformed (warped) in the thickness direction of the substrate, and specifically, rupture and cracking do not occur in the substrate even when the substrate is wound around a round bar having a diameter of x^{1/2} × 10 (cm) where x is the thickness of the substrate (µm).

The thickness of the substrate is not particularly limited, and is usually 10 µm to 100 µm, preferably 20 µm to 50 µm. The shape of the substrate in plan view is not particularly limited, and can be appropriately changed according to the disposition of the laminate to be laminated. In the present invention, a substrate having a substantially rectangular (belt-like) shape in plan view is used as illustrated in Fig. 1.

The front surface of the substrate may be provided with a barrier film as necessary. The formation material for the barrier film and the thickness of the barrier film are not particularly limited, but for example, it is preferable that as the barrier film, one similar to a protective film as described later is used.

### [Laminate]

As illustrated in Figs. 2 and 3, the laminate 3A of the organic EL device 1 according to one embodiment of the present invention includes at least the organic EL element 3. The organic EL element 3 includes the first conductive layer 31, the organic EL layer 32, and the second conductive layer 33 in this order, and is laminated on the substrate 2.

The laminate 3A according to the present invention further includes the protective film 34, the bonding layer 35, and the sealing plate 36 in this order on the organic EL element 3. The protective film 34 covers the organic EL element 3 except for the first terminal portion 311 and the second terminal portion 331. The sealing plate 36 is bonded on the protective film 34 with the bonding layer 35 interposed therebetween.

The protective film 34 serves to prevent damage to the organic EL element 3, and also serves to prevent permeation of moisture and oxygen. In Figs. 2 and 3, the protective film 34 covers the organic EL element 3 while being in direct contact with the organic EL element 3. Specifically, the protective film 34 covers the organic EL element 3 while being in direct contact with a front surface 332f of the second electrode portion 332, and outer peripheral surfaces (3a, 3b, 3c, and 3d) of the organic EL element 3.

The bonding layer 35 is provided for preventing damage to the organic EL layer 32, and bonding the sealing plate 36. The sealing plate 36 has moisture barrier properties, and serves to prevent moisture from coming into contact with the organic EL layer 32. The sealing plate 36 is provided on the organic EL element 3. Specifically, the sealing plate 36 is bonded on a front surface 35f of the bonding layer 35 provided on the organic EL element 3.

In Figs. 2 and 3, the bonding layer 35 is provided in direct contact with a front surface 34f and outer peripheral surfaces (34a, 34b, 34c, and 34d) of the protective film 34. The sealing plate 36 is provided in direct contact with the front surface 35f, a third side surface 35c, and a fourth side surface 35d of the bonding layer 35.

An organic EL layer is a laminate composed of at least two function layers. Examples of a structure of the organic EL layer include (A) a structure composed of three layers including a hole transport layer, a light emitting layer, and an electron transport layer; (B) a structure composed of two layers including a hole transport layer and a light emitting layer; and (C) a structure composed of two layers including a light emitting layer and an electron transport layer. In the organic EL layer of the above-mentioned (B), the light emitting layer also works as an electron transport layer. In the organic layer of the above-mentioned (C), the light emitting layer works as a hole transport layer.

The organic EL layer of the organic EL device according to the present invention may have any of structures of the above-mentioned (A) to (C). In this connection, all of the organic EL devices illustrated in Fig. 1 to Fig. 7 have a structure of (A). That is, the organic EL devices illustrated in Fig. 1 to Fig. 7 have an organic EL layer 32 with a three-layer structure in which a hole transport layer 321, a light emitting layer 322, and an electron transport layer 323 are laminated in the order from the bottom.

The hole transport layer 321 contained in the organic EL layer 32 has a function of injecting holes into the light emitting layer 322, and the electron transport layer 323 has a function of injecting electrons into the light emitting layer 322.

When electricity is allowed to flow through the first and second terminal portions 311 and 331, the electrons and the holes injected into the light emitting layer 322 from the first and second electrode portions 312 and 332 respectively are recombined to generate excited atoms (excitons). When the excitons return to the ground state, the light emitting layer 322 emits light.

Hereinafter, the first conductive layer 31 (anode layer), the hole transport layer 321, the light emitting layer 322, the electron transport layer 323, and the second conductive layer 33 (cathode layer), the protective film 34, the bonding layer 35, and the sealing plate 36 which the organic EL element 3 has will be described.

An anode layer is a film having conductivity.

The formation material for the anode layer is not particularly limited, but examples include indium tin oxide (ITO); indium tin oxide including silicon oxide (ITSO); aluminum; gold; platinum; nickel; tungsten; copper; and an alloy. The anode layer may be either transparent or opaque. When a bottom emission-type organic EL device is formed, a transparent formation material is used. A thickness of the anode layer is not particularly limited, but it is usually 0.01 µm to 1.0 µm.

As the formation method of the anode layer, an optimum method can be employed depending on the formation material, and examples of the method include a sputtering method, a vapor deposition method, and an ink-jet method. For example, when the anode layer is formed using a metal, the vapor deposition method can be used.

The hole transport layer is disposed on the front surface of the anode layer. The hole transport layer has a function of injecting holes in the light emitting layer.

A formation material for the hole transport layer is not particularly limited as long as the formation material has a hole transport function. Examples of the formation material for the hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N-bis(naphthalene-1-yl)-N,N'-bis(phenyl)-9,9'-spiro-bisfluorene (abbreviation: Spiro-NPB); a polymer compound; and the like. The formation material for the hole transport layer may be used alone or in combination of two or more types. Furthermore, the hole transport layer may have a multi-layer structure having two or more layers.

A thickness of the hole transport layer is not particularly limited, but the thickness of 1 nm to 500 nm is preferable from the viewpoint of reducing drive voltage of the organic EL device.

Furthermore, as the formation method of the hole transport layer, an optimum method can be employed depending on the formation material, and examples of the method include a sputtering method, a vapor deposition method, an ink-jet method, and a coating method.

A light emitting layer is disposed on the front surface of the hole transport layer.

A formation material for the light emitting layer is not particularly limited as long as it has light emitting property. Examples of the formation material for the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (Alq₃), and the like.

A thickness of the light emitting layer is not particularly limited, but the thickness of 2 nm to 500 nm is preferable, for example.

Furthermore, as the formation method of the light emitting layer, an optimum method can be employed depending on the formation material, and it is usually formed by a vapor deposition method.

The electron transport layer is disposed on the front surface of the light emitting layer (the back surface of the cathode layer). The electron transport layer has a function of injecting electrons in the light emitting layer.

A formation material for the electron transport layer is not particularly limited as long as it is a material having an electron transport function. Examples of the formation material for the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material for the electron transport layer may be used alone or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage of the organic EL device.

Furthermore, as the formation method of the electron transport layer, an optimum method can be employed depending on the formation material, and examples of the method include a sputtering method, a vapor deposition method, an ink-jet method, and a coating method.

The cathode layer is a film having conductivity.

A formation material for the cathode layer is not particularly limited. Examples of the formation material for the cathode layer which has conductivity include indium tin oxide (ITO); indium tin oxide including silicon oxide (ITSO); zinc oxide in which electric conductive metal such as aluminum is added (ZnO : Al); and a magnesium-silver alloy, and the like. The cathode layer may be either transparent or opaque. When a top emission-type organic EL device is formed, a transparent formation material is used. A thickness of the cathode layer is not particularly limited, but it is usually 0.01 µm to 1.0 µm.

As the formation method of the cathode layer, an optimum method can be employed depending on the formation material, and examples of the method include a sputtering method, a vapor deposition method, an ink-jet method. For example, the sputtering method is used when the cathode layer is formed of ITO, and the vapor deposition method is used when the cathode layer is formed of the laminated film of a magnesium-silver alloy or a magnesium-silver.

The formation material for the protective film is not particularly limited. The formation material for the protective film is, for example, a metal or a semimetal, preferably an oxide, an oxynitride, a nitride, or an oxycarbonitride thereof, or the like. Examples of oxide of a metal or a semimetal include MgO, SiO, SiₓO_{y} (X > 0, Y > 0), Al₂O₃, GeO, and Ti₂O.

The formation material for the protective film is preferably an oxynitride, a nitride or an oxycarbonitride of a semimetal, more preferably at least one selected from the group consisting of silicon oxycarbide (SiOC), silicon oxynitride (SiON), and silicon nitride (SiN). The thickness of the protective film is not particularly limited, but is, for example, 50 nm to 10 µm.

The formation material for the bonding layer is not particularly limited. For example, the bonding layer is formed using a previously known adhesive. As the adhesive, for example, a thermosetting adhesive or a photocurable adhesive can be used.

Examples of the thermosetting adhesive include adhesives mainly composed of an epoxy resin, a phenol resin, a polyurethane resin, or a melamine resin.

As the photocurable adhesive, typically an ultraviolet ray-curable adhesive can be used. Examples of the ultraviolet ray-curable adhesive include adhesives mainly composed of an ultraviolet ray-curable acrylic resin, an ultraviolet ray-curable urethane acrylate resin, an ultraviolet ray-curable polyester acrylate resin, an ultraviolet ray-curable polyurethane resin, an ultraviolet ray-curable epoxy acrylate resin, or an ultraviolet ray-curable imide acrylate resin.

The thickness of the bonding layer is not particularly limited, but is, for example, 5 µm to 50 µm,

The sealing plate is provided on the bonding layer. The formation material for the sealing plate is not particularly limited as long as it has moisture barrier properties. As a formation material for the sealing plate, for example, a synthetic resin such as an ethylene-tetrafluoroethyl copolymer (ETFE), high-density polyethylene (HDPE), an oriented polypropylene (OPP), polystyrene (PS), polymethyl methacrylate (PMMA), oriented nylon (ONy), polyethylene terephthalate (PET), polycarbonate (PC), polyimide, polyether styrene (PES) or polyethylene naphthalate (PEN) can be suitably used. Preferably, the sealing plate has flexibility. As a formation material for a sealing plate having flexibility, glass or a metal may be used. The sealing plate may be transparent, or may be opaque, but when a top emission-type organic EL device is to be formed, a transparent sealing plate is used.

The thickness of the sealing plate is not particularly limited, but is, for example, 5 µm to 1 mm, preferably 10 µm to 200 µm.

The back surface of the sealing plate may be provided with a barrier film as necessary. The formation material for the barrier film and the thickness of the barrier film are not particularly limited, but are preferably similar to those of the above-mentioned protective film.

### [Inorganic Film]

The inorganic film covers the laminate except for the first terminal portion and the second terminal portion. The inorganic film may cover the entire outer surface of the laminate (except for the first and second terminal portions), or may cover a part of the outer surface of the laminate.

As described above, a synthetic resin is generally used as a formation material for the bonding layer. However, a synthetic resin has relatively low moisture barrier properties, and therefore moisture coming into contact with the bonding layer may easily reach the organic EL layer. Although the sealing plate has moisture barrier properties, moisture barrier properties cannot be maintained over a long period of time with the sealing plate alone.

In this respect, in the organic EL device according to the present invention, moisture can be effectively prevented from reaching the organic EL layer because the laminate is covered with an insulating inorganic film. Since the inorganic film does not cover the first and second terminal portions, supply of electricity to the organic EL device by the connecting unit is not hindered.

For example, in Figs. 2 and 3, the inorganic film 4 covers the entire outer surface of the laminate 3A (except for the first and second terminal portions 311 and 331). Specifically, the inorganic film 4 is in direct contact with the sealing plate 36 and the bonding layer 35, and covers a front surface 36f and outer peripheral surfaces (36a, 36b, 36c, and 36d) of the sealing plate 36, and outer peripheral surfaces (35a, 35b, 35c, and 35d) of the bonding layer 35 without a break. Owing to the inorganic film 4, the moisture barrier properties of the organic EL device 1 can be maintained over a long period of time.

As described later, the organic EL device according to the present invention can be efficiently prepared by covering first and second terminal portions with a masking material, and then bring a substrate and a laminate into contact with a treatment liquid containing an inorganic substance. Accordingly, it is preferable that the front surface and outer peripheral surfaces of the sealing plate, and the outer peripheral surfaces of the bonding layer are covered with the inorganic film without a break from the viewpoint of production efficiency (for minimizing the portion to be covered with a masking material).

In the present invention, the substrate may be covered with the inorganic film, or may be not covered with the inorganic film. For example, when a material having moisture barrier properties (e.g. a metal) is used as a formation material for the substrate, the substrate may be not covered with the inorganic film, or may be covered with the inorganic film. On the other hand, when a material poor in moisture barrier properties (e.g. a synthetic resin) is used as a formation material for the substrate, it is preferable that the substrate is covered with the inorganic film.

When the substrate is covered with the inorganic film, the region of the substrate, which is covered with the inorganic film is not particularly limited, but preferably, a back surface 2e of the substrate is covered with the inorganic film, and more preferably, the entire outer surface of the substrate 2 is covered with the inorganic film 4 as illustrated in Figs. 2 and 3. The entire outer surface of the substrate 2 includes the back surface 2e and outer peripheral surfaces (2a, 2b, 2c, and 2d) of the substrate 2.

When the entire outer surface of the substrate 2 is covered with the inorganic film 4, the organic EL device 1 according to the present invention may have high moisture barrier properties. Accordingly, moisture can be effectively prevented from reaching the organic EL layer 32. In view of a method for producing the organic EL device 1 according to the present invention as described later, it is preferable that the inorganic film 4 covers the entire outer surface of the substrate 2 from the viewpoint of production efficiency.

The inorganic film is a film having insulation properties and moisture barrier properties, and contains an insulating inorganic substance as a main component.

The phrase "containing an insulating inorganic substance as a main component" means that the ratio (mass) of the insulating inorganic substance is the highest in all the components of the inorganic film, and includes not only a case where the inorganic film is composed of only the insulating inorganic substance, but also a case where the inorganic film contains a very small amount of other component (e.g. an insulating organic substance) within the bounds of not hindering the function (moisture barrier properties and insulation properties) of the inorganic film.

The insulating inorganic substance contained in the inorganic film is not particularly limited. The insulating inorganic substance may be a metal, or may be a semimetal.

Examples of the metal include zinc, aluminum, titanium, copper, and magnesium, and examples of the semimetal include silicon, bismuth, and germanium.

When a metal or a semimetal is used as a formation material for the inorganic film, the metal or the semimetal is preferably in the form of at least one selected from the group consisting of an oxide, a nitride, a carbide, an oxynitride, an oxycarbide, a carbonitride and oxycarbonitride.

The inorganic substance is preferably at least one selected from the group consisting of silicon oxide (SiO₂), silicon oxycarbide (SiOC), silicon oxynitride (SiON), and silicon nitride (SiN), with silicon oxide being especially preferable.

The formation method of the inorganic film is not particularly limited, and examples thereof include wet methods such as a dip coating method, a spray coating method, a roll coating method, a flow coating method and a gravure printing method; and dry methods such as a vapor deposition method, a sputtering method, and a CVD method. Preferably, the inorganic film is formed by a wet method from the viewpoint of production efficiency.

The inorganic substance is especially preferably a silica-converted product obtained by subjecting a polysilazane as an inorganic macromolecular compound to a silica conversion reaction. The silica-converted product contains silicon oxide. The inorganic film can be efficiently formed because the silica-converted product can be applied by a wet method, and an inorganic film having a relatively high water vapor barrier property can be formed by using the silica-converted product.

The polysilazane is an inorganic macromolecular compound having a silicon-nitrogen bond in the main chain component thereof, and serves as a ceramic precursor. The silica-converted product obtained by subjecting a polysilazane to a silica conversion reaction may contain an unconverted product such as, for example, silicon nitride or silicon hydroxide in addition to silicon oxide.

In the present specification, the "inorganic macromolecular compound" includes a macromolecular compound of which the main chain component is composed of elements other than carbon (e.g. metal atoms, semimetal atoms, oxygen, nitrogen, or the like). The side chain component of the inorganic macromolecular compound may include carbon.

Preferably, the polysilazane has a repeating unit represented by the following general formula (1).

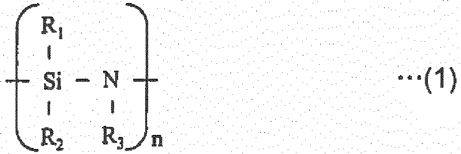

In the general formula (1), R₁, R₂, and R₃ each independently represent a hydrogen atom, an alkyl group with a carbon number of 1 to 8, which may have a substituent, an alkenyl group with a carbon number of 2 to 6, which may have a substituent, a cycloalkyl group with a carbon number of 3 to 6, which may have a substituent, an aryl group which may have a substituent, an alkylsilyl group with a carbon number of 1 to 4, which may have a substituent, an alkylamino group with a carbon number of 1 to 4, which may have a substituent, or an alkoxy group with a carbon number of 1 to 4, which may have a substituent; and n represents an integer of 1 to 60.

Preferably, R₁, R₂, and R₃ are each a hydrogen atom or an alkyl group with a carbon number of 1 to 4, which may have a substituent, and more preferably, R₁, R₂, and R₃ are each a hydrogen atom in the general formula (1).

When a polysilazane with R₁, R₂. and R₃ being each a hydrogen atom (perhydropolysilazane) is used, the denseness of the silica-converted product is improved, and therefore an inorganic film excellent in moisture barrier properties can be formed.

When at least one selected from R₁, R₂, and R₃ is an alkyl group with a carbon number of 1 to 8, plasticity can be imparted to the structure of the polysilazane. When plasticity is imparted to the structure of the polysilazane, plasticity can also be imparted to the silica-converted product therefrom, so that cracking is hard to occur even when the thickness of the inorganic film is increased.

In the present invention, it is preferable to use a polysilazane having both a repeating unit A with R₁, R₂, and R₃ being each a hydrogen atom and a repeating unit B with some or all of R₁, R₂, and R₃ being alkyl groups with a carbon number 1 to 8. By changing the ratio between the repeating unit A and the repeating unit B, the plasticity of the inorganic film can be appropriately adjusted while sufficient moisture barrier properties is secured.

The thickness of the inorganic film is not particularly limited. Of course, when the thickness of the inorganic film is too thin, there is a fear that the moisture barrier properties of the organic EL device cannot be maintained for a long period of time. Moreover, when the thickness of the inorganic insulating film is too thick, there is a fear that a crack is easily generated, and the moisture barrier properties is lowered.

From such a viewpoint, the thickness of the inorganic insulating film is preferably 10 nm to 3 µm, more preferably 50 nm to 2 µm, further preferably 0.1 µm to 1 µm, particularly preferably 0.3 µm to 0.5 µm.

Modified examples of the present invention will be described below. In this regard, configurations and effects different from those of the above-described embodiment will be described upon explanation of the following modified examples, and the same configurations and the like as those of the above-described embodiment will not be described and terms and reference numerals are employed in some cases.

### [First Modified Example]

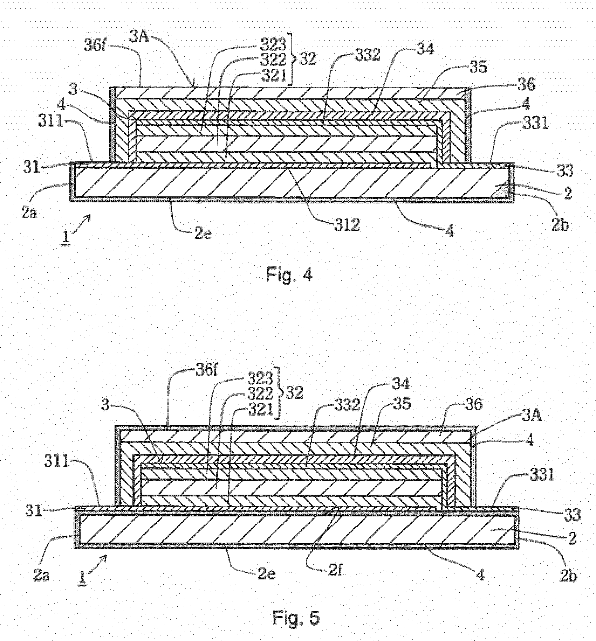

Fig. 4 is an enlarged sectional view illustrating an organic EL device 1 according to the first modified example of the present invention. The enlarged sectional view of the organic EL device 1 in Fig. 4 is an enlarged sectional view of the organic EL device 1 cut in a position similar to that of the line II-II in Fig. 1 (the same is the case with Figs. 5 to 7).

In this modified example, an inorganic film 4 is provided on a part of the outer surface of a laminate 3A. Specifically, in the laminate 3A of this modified example, a front surface 36f of a sealing plate 36 is not covered with the inorganic film 4. In other words, the front surface 36f of the sealing plate 36 is exposed to the outside air. Since the sealing plate 36 has moisture barrier properties, degradation of the organic EL device 1 by moisture can be prevented also in this modified example.

### [Second Modified Example]

Fig. 5 is an enlarged sectional view illustrating an organic EL device 1 according to a second modified example of the present invention.

The organic EL device 1 according to this modified example has the same configuration as that in the above-described embodiment except that the whole area of a substrate 2 is covered with an inorganic film 4. The whole area of the substrate includes a front surface 2f, a back surface 2e, and outer peripheral surfaces (2a, 2b, 2c, and 2d) of the substrate 2.

The organic EL device 1 according to this modified example has higher moisture barrier properties because the whole area of the substrate 2 is covered with the inorganic film 4.

### [Third Modified Example]

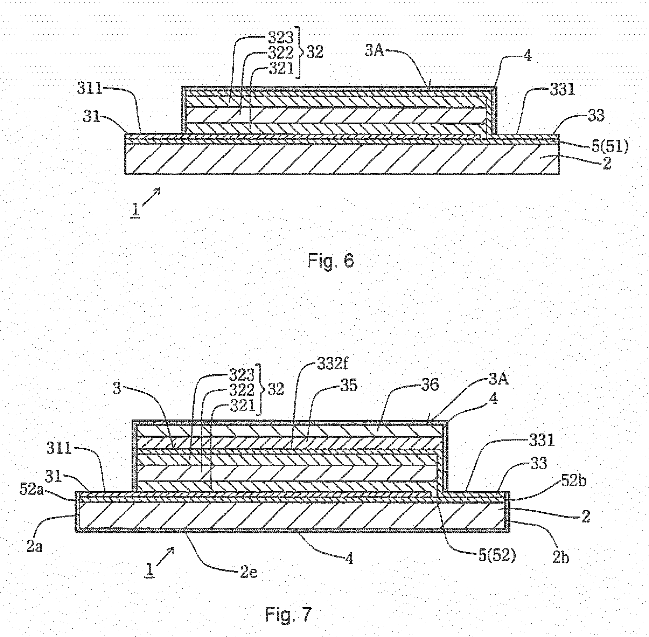

Fig. 6 is an enlarged sectional view illustrating an organic EL device 1 according to a third modified example of the present invention.

In this modified example, a laminate 3A is composed of only an organic EL element 3, and does not include a protective film, a bonding layer, and a sealing plate. An inorganic film 4 covers the organic EL element 3 (i.e. laminate 3A) while being in direct contact with the organic EL element 3 except for first and second terminal portions 311 and 331.

Although a protective film, a bonding layer, and a sealing plate do not exist, the moisture barrier properties of the organic EL device 1 can be maintained over a long period of time because the organic EL element 3 is directly covered with the inorganic film 4.

In this modified example, a material having conductivity and moisture barrier properties is used as a formation material for the substrate 2. The substrate 2 formed of a material having conductivity and moisture barrier properties (e.g. a conductive substrate formed of a metal, etc.) is not required to be covered with the inorganic film 4. Therefore, in Fig. 6, the substrate 2 is not covered with the inorganic film 4.

The organic EL device 1 according to the third modified example has an insulating layer 5 provided between the substrate 2 and the organic EL element 3. The insulating layer 5 is a layer that serves to prevent occurrence of a short-circuit between first and second conductive layers 311 and 331 and the substrate 2. In this modified example, an inorganic insulating layer 51 formed using an inorganic substance having insulation properties and moisture barrier properties is employed. Since the inorganic insulating layer 51 has moisture barrier properties, the substrate 2 may be covered with the inorganic film 4, or may be not covered with the inorganic film 4.

As the inorganic substance having insulation properties and moisture barrier properties, one similar to the formation material for the inorganic film as described above can be used.

The thickness of the inorganic insulating layer is not particularly limited. Of course, when the thickness of the inorganic insulating layer is too thin, there is a fear that a pinhole is easily generated, and the insulation properties are lowered. Moreover, when the thickness of the inorganic insulating layer is too thick, there is a fear that a crack is easily generated, and the insulation properties are lowered.

From such a viewpoint, the thickness of the inorganic insulating layer is preferably 10 nm to 5 µm, more preferably 50 nm to 2 µm, further preferably 0.1 µm to 1 µm, particularly preferably 0.3 µm to 0.5 µm.

Although the formation method of an inorganic insulating layer is not particularly limited, a dry method such as a vapor deposition method, a sputtering method, and a CVD method, a wet method such as a sol-gel method, or the like can be employed.

### [Fourth Modified Example]

Fig. 7 is an enlarged sectional view illustrating an organic EL device 1 according to a fourth modified example of the present invention. In this modified example, an insulating layer 5 formed using an insulating synthetic resin (organic insulating layer 52) is provided between an organic EL element 3 and a substrate 2. In this modified example, a laminate 3A does not include a protective film, and a bonding layer 35 is provided on a front surface 332f of a second electrode portion 332.

The organic insulating layer 52 is inferior in moisture barrier properties to the inorganic insulating layer. Therefore, it is preferable that outer peripheral surfaces (52a, 52b, 52c, and 52d) of the organic insulating layer 52 are also covered with an inorganic film 4.

When the outer peripheral surfaces of the organic insulating layer 52 are covered with the inorganic film 4, permeation of moisture from the outside of the organic insulating layer 52 can be effectively prevented.

The insulating synthetic resin contained in the organic insulating layer is not particularly limited. Examples of the synthetic resin described above include acrylic resins, norbornene resins, epoxy resins, polyimide resins, polyamideimide resins, polyamide resins, polyester resins, polyarylate resins, polyurethane resins, polycarbonate resins, polyether ketone resins, polyphenyl sulfone resins, and combinations of these resins.

The thickness of the organic insulating layer is not particularly limited. Of course, when the thickness of the organic insulating layer is too thin, there is a fear that the front surface of the substrate cannot be sufficiently smoothed, and in addition, a short circuit cannot be sufficiently prevented. On the other hand, when the thickness of the organic insulating layer is too thick, there is a fear that the adhesive properties to the substrate are lowered.

As such, the thickness of the organic insulating layer is preferably 1 µm to 40 µm, more preferably 0.5 µm to 20 µm, further preferably 0.5 µm to 10 µm, particularly preferably 1 to 5 µm.

The formation method of the organic insulating layer is not particularly limited, and coating by roll coating, spray coating, spin coating, dipping, and the like can be employed.

### [Method for Producing Organic EL Device]

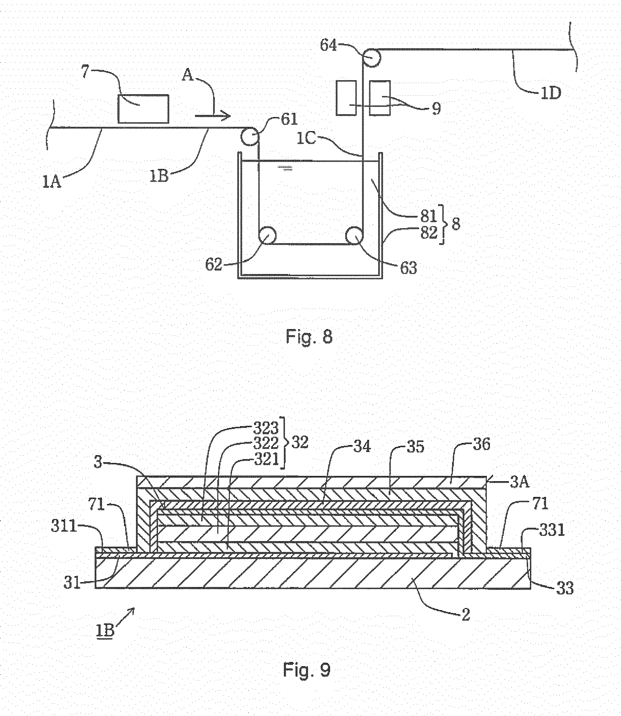

Hereinafter, a method for producing an organic EL device according to the present invention will be described with reference to Fig. 8.

Fig. 8 is a schematic side view illustrating a production line in the following steps 2 to 4 in preparation of an organic EL device by a roll-to-roll method.

The method for producing an organic EL device according to the present invention includes at least the following five steps:
(Step 1) a step of forming on a substrate a laminate including an organic EL element which includes a first conductive layer having a first terminal portion, an organic EL layer, and a second conductive layer having a second terminal portion;
(Step 2) a step of covering each of the first terminal portion and the second terminal portion with a masking material;
(Step 3) a step of bringing the laminate into contact with a treatment liquid containing an insulating inorganic substance;
(Step 4) a step of solidifying the treatment liquid to form an inorganic film; and
(Step 5) a step of removing the masking material covering the first terminal portion and the second terminal portion.

According to the method for producing an organic EL device according to the present invention, the treatment liquid is deposited on the whole area of the outer surface of the laminate except for portions covered with the masking material (first and second terminal portions). As a result, an organic EL device can be easily produced in which a laminate is covered with an inorganic film except for a first terminal portion and a second terminal portion, and further, a substrate is covered with the inorganic film.

Hereinafter, the steps will be described.

The step 1 is a step of forming a laminate on a substrate to obtain a laminate with a substrate. The formation method of the first conductive layer, the organic EL layer, and the second conductive layer is as described above. A protective film, a bonding layer, or a sealing plate is laminated on the organic EL element as necessary.

The substrate to be used in the step 1 may be covered with the inorganic film beforehand. That is, a step of covering with the inorganic film the substrate which is not covered with the inorganic film may be provided before the step 1.

When a substrate covered with an inorganic film is used, an organic EL device can be obtained in which the whole area of the substrate is covered with the inorganic film as illustrated in Fig. 5.

The substrate to be used in the step 1 is preferably a long substrate. When a long substrate is used, an organic EL device can be efficiently formed by a roll-to-roll method.

That is, when a long substrate is used, a roll-shaped laminate with a substrate can be efficiently obtained by delivering a roll body of a long substrate in the longitudinal direction of the substrate, forming a laminate on a front surface of the delivered long substrate, and then winding the substrate and the laminate.

Descriptions of steps 2 to 4 below are based on the premise that a roll-to-roll method is employed. However, the method for producing an organic EL device according to the present invention is not limited to the roll-to-roll method, and other methods such as a batch method may be used.

The step 2 is a step of covering with a masking material a portion to be prevented from coming into contact with a treatment liquid as a pretreatment for the step 3 of bringing a treatment liquid into contact with the laminate.

As illustrated in Fig. 8, the laminate 1A with a substrate, which is obtained in the step 1, is conveyed from the upstream side to the downstream side in the conveyance direction by rotary rollers 61, 62, 63, and 64. The arrow A shown in Fig. 8 illustrates the conveyance direction of the laminate with a substrate (1A, 1B, 1C, and 1D). The laminate 1A with a substrate is covered with a masking material to obtain a laminate 1B with a substrate, which is covered with a masking material.

Fig. 9 is an enlarged sectional view illustrating the laminate 1B with a substrate after the step 2. In the laminate 1A with a substrate, at least first and second terminal portions 311 and 331 are covered with a masking material 71 by a masking device 7 as illustrated in Figs. 8 and 9.

The masking device 7 is not particularly limited, and can be appropriately changed according to the type of a masking material. For example, as described later, the masking device 7 is a sticking device when a masking tape is employed as the masking material, and the masking device 7 is a coater when a masking ink is employed as the masking material.

The masking material may be provided so as to cover not only first and second terminal portions but also other portions (e.g. the front surface of the sealing plate when the laminate includes the sealing plate). Preferably, the masking material is provided so as to cover only first and second terminal portions.

Any masking material may be used without particular limitation.

For example, the masking material may be a masking tape in which a bonding layer formed of a pressure sensitive adhesive is laminated on one surface of a base material film, or may be a masking ink containing a synthetic resin. As the formation material for the masking material, one that is not soluble in a treatment liquid as described later is used.

When a masking ink is used as the masking material, it is necessary to dry and cure the masking ink before the step 3. At the time of applying the masking ink to first and second terminal portions, the masking ink may be deposited on portions other than both the terminal portions. Therefore, a masking tape is preferably used as the masking material. By using a masking tape, first and second terminal portions can be conveniently and reliably covered.

The step 3 is a step of bringing the laminate 1B with a substrate, which is covered with the masking material, into a treatment liquid to deposit the treatment liquid thereon.

In Fig. 8, the laminate 1B with a substrate is carried into a tank 82 filled with a treatment liquid 81 (treatment tank 8), and is then drawn up from the treatment tank 8. In this way, the treatment liquid is brought into contact with the laminate 1B with a substrate in the treatment tank 8 to obtain a laminate 1C with a substrate with a treatment liquid deposited thereon.

The method for bringing the laminate 1B with a substrate and the treatment liquid 81 into contact with each other is not limited to the method using the treatment tank 8 (dip coating method), and any contact method such as a spray coating method, a roll coating method, a flow coating method, or a gravure printing method may be employed.

The treatment liquid contains an insulating inorganic substance and a solvent. The insulating inorganic substance is similar to the inorganic substance contained in the inorganic film.

The solvent is not particularly limited as long as it allows an inorganic substance to be dissolved or dispersed therein, and any solvent may be used.

As such a solvent, for example, a hydrocarbon solvent such as an aliphatic hydrocarbon, a cycloaliphatic hydrocarbon, or an aromatic hydrocarbon, a halogenated hydrocarbon solvent, or an ether such as an aliphatic ether or a cycloaliphatic ether can be used.

When a silane-converted product from a polysilazane is used as an inorganic substance, it is not preferable to use a solvent containing an alcohol or water having high reactivity with a polysilazane.

When a silane-converted product from a polysilazane is used as an inorganic substance, a hydrocarbon such as pentane, hexane, cyclohexane, toluene, xylene, Solvesso [registered trademark] or Terpene; a halogenated hydrocarbon such as methylene chloride or trichloroethane; or dibutyl ether, dioxane, tetrahydrofuran, or the like is preferably used as a solvent.

Various kinds of catalysts can also be added in the solvent for promoting silane conversion reaction of the polysilazane. Examples of the catalyst include metal catalysts such as gold, silver, palladium, platinum, and nickel, and carboxylic acid complexes thereof.

The concentration of the inorganic substance in the treatment liquid is not particularly limited, but is usually 0.1% by mass to 40% by mass.

When the concentration of the inorganic substance is less than 0.1% by mass, the thickness of the inorganic film decreases, so that it may be unable to secure moisture barrier properties sufficiently.

The treatment liquid is deposited on the laminate 1C with a substrate at the time when the laminate 1C with a substrate is drawn up from the treatment tank 8. The laminate 1C with a substrate after leaving the treatment tank 8 has a thin layer of the deposited treatment liquid.

The amount of the treatment liquid deposited on the laminate 1C with a substrate can be appropriately adjusted according to the viscosity of the treatment liquid 81 and the draw-up speed (conveyance speed) of the laminate 1C with a substrate.

The step 4 is a step of solidifying the treatment liquid deposited on the laminate with a substrate to form an inorganic film.

In the method for producing an organic EL device according to the present invention, the step of forming an inorganic film from the treatment liquid deposited on the laminate with a substrate is provided between the step 3 and the step 4, or after the step 4.

The formation method of an inorganic film can be appropriately changed according to the type of an inorganic substance contained in the treatment liquid. For example, when the inorganic substance is a metal or a semimetal, an inorganic film can be formed by volatilizing the solvent contained in the thin layer of the treatment liquid (drying the treatment liquid). The treatment liquid may be naturally dried, or forcedly dried by a dryer, or may be dried by combination of natural drying and forced drying by a dryer.

When the thin layer of the treatment liquid is naturally dried while the laminate 1C with a substrate is conveyed, drying by a dryer may be omitted.

In Fig. 8, the treatment liquid 81 deposited on the laminate 1C with a substrate is dried by a dryer 9. Preferably, the drying is performed before the thin layer of the treatment liquid comes into contact with foreign matters on a roller etc. For example, as illustrated in Fig. 8, the dryer 9 is disposed between the liquid surface in the treatment tank 8 and a rotary roller 64.

When the inorganic substance contained in the treatment liquid is a polysilazane, the treatment liquid passes through a silica conversion treatment of the polysilazane in addition to the drying to form an inorganic film.

The silica conversion treatment of the polysilazane is achieved by, for example, subjecting the treatment liquid to a steam oxidation treatment and/or a heating oxidation treatment. By the silica conversion treatment of the polysilazane, a most part of the polysilazane contained in the treatment liquid is converted into silicon oxide to form an inorganic film containing a silica-converted product.

The silica conversion treatment of the polysilazane is preferably a steam oxidation treatment. For example, the laminate with a substrate is exposed to steam for a predetermined time in a high-temperature and high-humidity bath (e.g. 60°C and 90% RH) to perform the steam oxidation treatment (not illustrated).

The step 5 is a step of removing the masking material from a laminate 1D with a substrate, the whole area of the outer surface of which is covered with the inorganic film. By removing the masking material from the laminate 1D with a substrate, portions which have been covered with the masking material is exposed, so that an organic EL device can be obtained.

In the laminate 1D with a substrate, at least the first terminal portion and the second terminal portion are covered with the masking material as described above. Therefore, by removing the masking material, an organic EL device can be obtained in which at least the first and second terminal portions are not covered with an inorganic film (i.e. first and second terminal portions are exposed to the outside air).

The method for removing the masking material is not particularly limited, and can be appropriately changed according to the type of a masking material. For example, when a masking tape is used as the masking material, the masking material can be removed by peeling off the masking tape.

In the method for producing an organic EL device according to the present invention, the organic EL device is obtained through the step 5 (step of removing the masking material) after the step 4 (solidifying the treatment liquid deposited on the laminate with a substrate).

However, in the present invention, the step 4 and the step 5 are not necessarily required to be performed in this order, and the organic EL device can also be obtained through the step 4 after the step 5.

However, when the step 4 is performed after the step 5, an unsolidified treatment liquid may be deposited on a portion exposed due to removal of the masking material. Therefore, it is preferable that the organic EL device is obtained through the step 5 after the step 4.

The organic EL device according to the present invention, and the method for producing the organic EL device are not limited to the embodiments described above, and can be appropriately changed within the intended scope of the present invention.

### INDUSTRIAL APPLICABILITY

The organic EL device of the present invention can be used for illuminating devices, image displays, and the like.

1 Organic EL device, 2 Substrate, 3A Laminate, 3 Organic EL element, 31 First conductive layer, 311 First terminal portion, 32 organic EL layer, 33 Second conductive layer, 331 Second terminal portion, 34 Protective layer, 35 Bonding layer, 36 Sealing plate, 4 Inorganic film, 71 Masking material

## Claims

1. An organic electroluminescence device comprising:
a substrate;
a laminate including an organic electroluminescence element which includes a first conductive layer provided on the substrate and having a first terminal portion, an organic electroluminescence layer provided on the first conductive layer, and a second conductive layer provided on the organic electroluminescence layer and having a second terminal portion; and
an insulating inorganic film that covers the laminate except for the first terminal portion and the second terminal portion.

2. The organic electroluminescence device according to claim 1, wherein the insulating inorganic film further covers the substrate.

3. The organic electroluminescence device according to claim 1 or 2, wherein the insulating inorganic film contains a silica-converted product from a polysilazane.

4. The organic electroluminescence device according to any one of claims 1 to 3, wherein the laminate further includes a bonding layer provided on the organic electroluminescence element, and a sealing plate bonded to the organic electroluminescence element by the bonding layer.

5. The organic electroluminescence device according to any one of claims 1 to 3, wherein the laminate further includes a protective film provided on the organic electroluminescence element, a bonding layer provided on the protective film, and a sealing plate bonded to the protective film by the bonding layer.

6. The organic electroluminescence device according to claim 4 or 5, wherein the sealing plate has flexibility.

7. The organic electroluminescence device according to any one of claims 1 to 6, wherein the substrate has flexibility.

8. A method for producing an organic electroluminescence device, the method comprising the steps of:
forming on a substrate a laminate including an organic electroluminescence element which includes a first conductive layer having a first terminal portion, an organic electroluminescence layer, and a second conductive layer having a second terminal portion;
covering the first terminal portion and the second terminal portion with a masking material;
bringing the laminate into contact with a treatment liquid containing an insulating inorganic substance;
solidifying the treatment liquid to form an inorganic film; and
removing the masking material.

9. The method for producing an organic electroluminescence device according to claim 8, wherein the treatment liquid contains a polysilazane, and
the step of solidifying the treatment liquid includes a silica conversion treatment of the polysilazane.
